# EUROPEAN PATENT APPLICATION

(11) **EP 3 382 895 A1**
(43) Date of publication of application: **03.10.2018**
(21) Application number: 16868301.9
(22) Date of filing: 21.10.2016
(51) Int. Cl.: H03K 17/00, B60R 16/02, G01R 31/00, G01R 31/02

(54) **ELECTRONIC DEVICE PROVIDED WITH SECONDARY FAILURE PREVENTING CIRCUIT**

(30) Priority: 23.11.2015 JP 2015228253
(71) Applicant: Bosch Corporation, Tokyo 150-8360 (JP)
(72) Inventor: ISHIKURA Takayuki, Yokohama-shi Kanagawa 224-8501 (JP)
(74) Representative: Bee, Joachim
(86) International application number: PCT/JP2016/081207
(87) International publication number: WO 2017/090352

(57) **Abstract**

The invention reliably prevents secondary damage, failure, or the like of an electronic component having a certain power supply voltage, arising from breakage of a common ground wire to electronic components having different power supply voltages.

In the case where an electric potential on a ground side of each of first and second sensors 1, 2 falls below a specified reference voltage, a 5-V power supply voltage is supplied to the first and second sensors 1, 2 via a secondary failure preventing circuit 102. Meanwhile, in the case where a shared ground wire 32 is broken and the electric potential on the ground side of each of the first and second sensors 1, 2 exceeds the specified reference voltage, the secondary failure preventing circuit 102 blocks a supply of the 5-V power supply voltage to the first and second sensors 1, 2, and generation of a reverse current from a vehicle battery 51 to second and fourth sensors 3, 4 is prevented.

## Description

### Technical Field

The invention relates to prevention of failure occurred to an electronic component in an electronic circuit and, in particular, to prevention of secondary failure occurred to an electronic component, arising from breakage of a common ground wire to plural electronic components.

### Background Art

As it has been well known, a device referred to as an electronic device, an electronic system, or the like has any of various configurations in accordance with a required control operation and the like. The device referred to as the electronic device, the electronic system, or the like has a so-called microcomputer and the like and performs a desired control operation on the basis of various sensors, data generated therein, and the like.

From perspectives of simplification of the device configuration, price reduction of the device, and the like, it is desired that such an electronic device or the like has the minimum number of electronic components to be used and that only one type of a power supply voltage is sufficient as a required power supply for a circuit operation. However, there is a case where plural power supply voltage systems are provided in relation to the desired control operation and the like, for example.

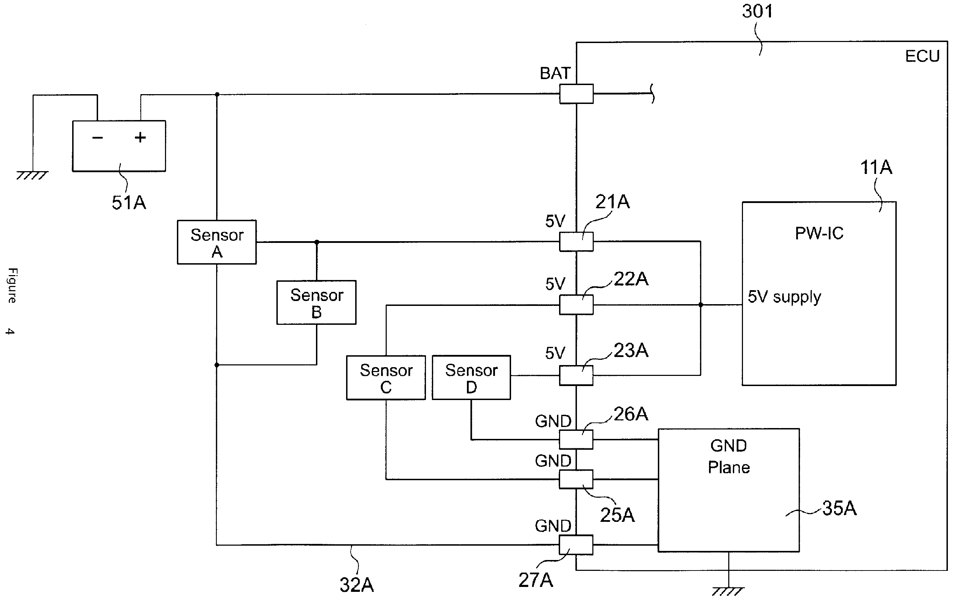

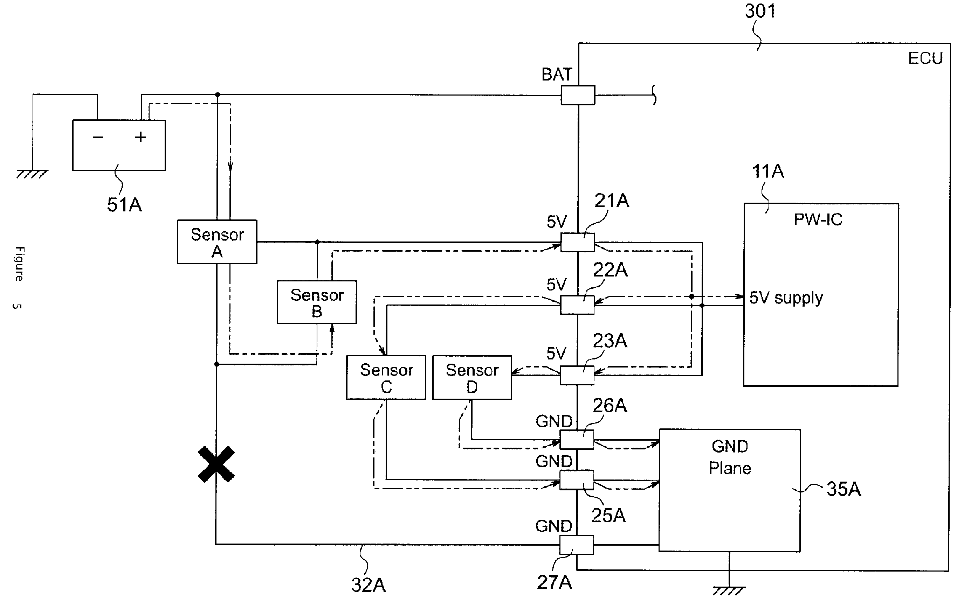

Fig. 4 and Fig. 5 each depict a configuration example of such a conventional electronic device. Hereinafter, the conventional device will be described by using the same drawings.

This conventional device is an example of the electronic device that electrically realizes various types of operation control required for a motor vehicle.

This electronic device is constructed of a vehicle electronic control unit (described as "ECU" in Fig. 4) 301 as a central component. The vehicle electronic control unit 301 has: an IC (not depicted) that has functions such as arithmetic operations and control represented by a microcomputer (not depicted); an interface circuit (not depicted) connected to an external circuit; and the like, and is configured to be able to execute the operation control of an engine and the like on the basis of detection signals acquired by plural sensors, signals from various types of unillustrated switches, and the like.

This vehicle electronic control unit 301 receives the detection signals from four sensors A to D as the plural sensors, for example.

The vehicle electronic control unit 301 is provided with a power supply IC (described as "PW-IC" in Fig. 4 and Fig. 5) 11A that converts a battery voltage (for example, 12 V) supplied from a vehicle battery 51A to a prescribed voltage, such as 5 V, required in the electronic circuit and stabilizes and outputs the converted voltage, so as to supply generated 5 V to an unillustrated circuit, the sensors A to D, and the like.

Normally, only one power supply voltage system, that is, a 5-V power supply voltage system in this example is provided for many of the sensors. However, some of the sensors require two different power supply voltages in relation to the functions thereof and the like. For example, the sensor A requires both of the power supply voltage (for example, 12 V) from the vehicle battery 51A and 5 V from the power supply IC 11A.

The ground for these sensors A to D is collected on a ground plate material 35A that is provided in the vehicle electronic control unit 301, and is connected to a vehicle earth via this ground plate material 35A.

In such a configuration, the ground of the sensors A to D is connected to ground connection terminals 25A to 27A that are provided in the vehicle electronic control unit 301 while being also connected to the vehicle electronic control unit 301, the other external circuit (not depicted), and another electronic control device (not depicted). Thus, the sufficient number of ground terminals and 5-V power supply terminals are not always provided in the electronic device.

More specifically, it is configured in this example that, while the sensor C and the sensor D are connected to 5-V power supply terminals 22A, 23A and the ground terminals 25A, 26A that are separately provided in the vehicle electronic control unit 301, the sensor A and the sensor B share a single 5-V power supply terminal 21A and a shared ground terminal 27A, and the sensor A is also supplied with the battery voltage from the vehicle battery 51A.

In such a configuration, a mutual connection point on the ground sides of the sensor A and the sensor B is connected to the shared ground terminal 27A by a shared ground wire 32A (see Fig. 4). In the case where the shared ground wire 32A is broken for some reason (see a symbol X in Fig. 5), as indicated by two-dot chain lines in Fig. 5, a reverse current flows from the vehicle battery 51A into the 5-V power supply terminal 21A, which is shared by the sensor A and the sensor B, via these sensors A, B. It is because the battery voltage (12 V) is higher than the output voltage of the power supply IC 11A.

Then, in the vehicle electronic control unit 301, the reverse current flows into the power supply IC 11A via a common 5-V supply wire that is connected to the 5-V power supply terminal 21A shared by the sensors A, B, also flows into the sensors C, D, and eventually reaches the commonly connected vehicle ground from these power supply IC 11A and ground sides of the sensors C, D.

As a result, in the case where a magnitude of the reverse current, which has flowed into each of the electronic components just as described, exceeds a limit value of the reverse current therefor, the reverse current possibly leads to so-called secondary failure such as damage or failure of the electronic components.

Various measures of detecting the breakage in the electronic device or the like have been proposed and put into practical use, and an example of such a measure is a circuit capable of detecting breakage of a load and suppressing a voltage increase of the load (for example, see PTL 1 and the like).

### Citation List

### Patent Literature

[PTL 1] JP-A-2008-11347 (pages 4 to 6, Fig. 1 to Fig. 8)

### Disclosure of Invention

### Technical Problem

For example, the circuit disclosed in PTL 1 can protect the load itself, the breakage of which occurs. However, unlike the component itself, the breakage of which occurs, the circuit disclosed in PTL 1 cannot prevent damage, failure, or the like of a component in advance that has a high possibility of secondary damage, failure, or the like occurred thereto, arising from the breakage, that is, the sensors C, D in the electronic device with the configuration that has been described above with reference to Fig. 4 and Fig. 5.

The invention has been made in view of the above circumstance and therefore provides a secondary failure preventing circuit that can reliably suppress or prevent secondary damage, failure, or the like of an electronic component having a certain power supply voltage, arising from breakage of a common ground wire to electronic components having different power supply voltages.

### Solution to Problem

In order to achieve the above purpose of the invention, an electronic device that includes a secondary failure preventing circuit according to the invention includes:
a dual power-supply type electronic component that requires a first power supply voltage and a second power supply voltage that is lower than the first power supply voltage; a first single power-supply type electronic component that requires the second power supply voltage; at least one wire-unshared single power-supply type electronic component that requires the second power supply voltage; a unit power supply circuit that generates and outputs the second power supply voltage on the basis of the first power supply voltage; and a secondary failure preventing circuit that prevents generation of a reverse current to the wire-unshared single power-supply type electronic component, arising from breakage of a common ground wire to the dual power-supply type electronic component and the first single power-supply type electronic component.

### Advantageous Effects of Invention

According to the invention, when the common ground wire to the dual power-supply type electronic component and the single power-supply type electronic component is broken, a secondary preventing circuit blocks application of the second power supply voltage to the dual power-supply type electronic component and the single power-supply type electronic component. In this way, the generation of the reverse current from the dual power-supply type electronic component side to the other single power-supply type electronic component through a single power-supply type electronic portion, a ground side of which is connected to this dual power-supply type electronic component by the common ground wire is prevented and avoided. Thus, secondary failure of the other single power-supply type electronic component is reliably prevented or reduced. Therefore, an effect of improving reliability and safety of the entire electronic device is exerted.

### Brief Description of Drawings

Fig. 1 is a basic configuration diagram of an electronic device provided with a secondary failure preventing circuit in an embodiment of the invention.
Fig. 2 is a circuit diagram illustrating a specific circuit configuration example of the secondary failure preventing circuit in the embodiment of the invention.
Fig. 3 is a circuit diagram illustrating another example of a supply path of a second power supply voltage from a unit power supply circuit that is provided in the electronic device provided with the secondary failure preventing circuit in the embodiment of the invention.
Fig. 4 is a circuit diagram illustrating a connection example between a power supply voltage and the ground in a conventional electronic device.
Fig. 5 is a circuit diagram illustrating a path of a reverse current that is generated in the case of breakage of a common ground wire in the conventional electronic device depicted in Fig. 4.

### Description of Embodiments

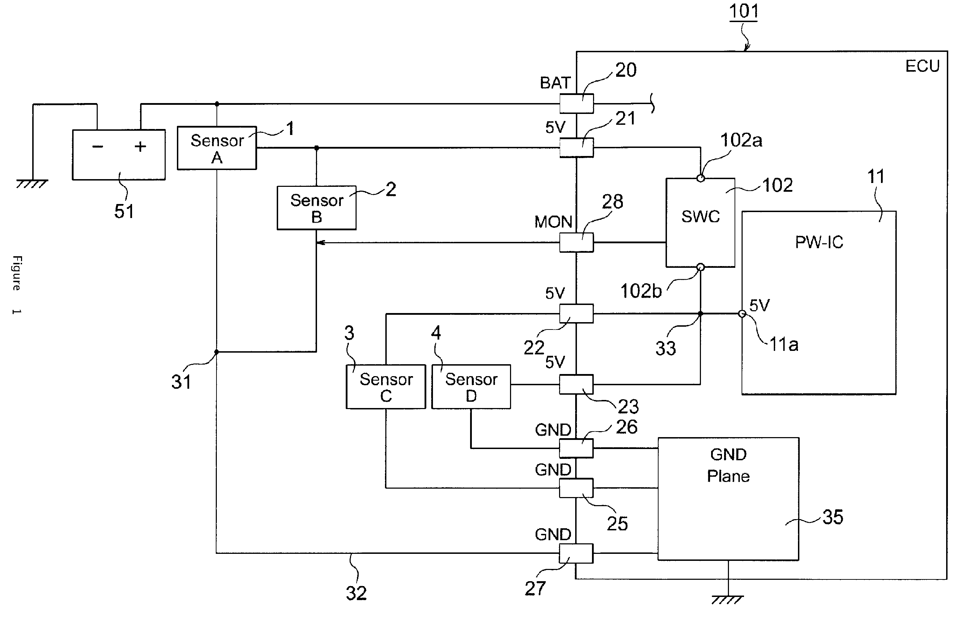

A description will hereinafter be made on an embodiment of the invention with reference to Fig. 1 to Fig. 3.

Note that members, arrangement, and the like, which will be described below, do not limit the invention, and various changes can be made thereto within the scope of the spirit of the invention.

First, a description will be made on a basic configuration of an electronic device that includes a secondary failure preventing circuit in the embodiment of the invention with reference to Fig. 1.

Fig. 1 depicts a configuration example of an electronic device for vehicle operation control, and the electronic device is constructed of a so-called vehicle electronic control unit 101 as a primary component that executes operation control of a motor vehicle. A description will hereinafter be made on a configuration of the vehicle electronic control unit 101.

For example, the vehicle electronic control unit 101 has a microcomputer (not depicted) as a central component, a storage device (not depicted), and an interface circuit (not depicted) and is provided with a power supply IC (described as "PW-IC" in Fig. 1) 11 as a unit power supply circuit. The power supply IC 11 generates a power supply voltage (a second power supply voltage), such as 5 V, that is required for operations of the microcomputer and the like on the basis of a battery voltage (for example, 12 V) as a first power supply voltage that is supplied from a vehicle battery 51 provided on the outside, and carries out processing such as stabilization of the power supply voltage for output.

As will be described below, for electrical connection with the outside, the vehicle electronic control unit 101 is provided with a battery connection terminal (described as "BAT" in Fig. 1) 20, first to third unit voltage supply terminals 21 to 23, first to third ground connection terminals (described as "GND" in Fig. 1) 25 to 27 and a monitor terminal (described as "MON" in Fig. 1) 28.

First to fourth sensors (described as a "Sensor A", a "Sensor B", a "Sensor C", and a "Sensor D" in Fig. 1) 1 to 4 are provided on the outside of this vehicle electronic control unit 101, and detection signals thereof are received by the vehicle electronic control unit 101 and used for the processing such as engine control.

Note that what type of a sensor each of the above-described sensors 1 to 4 is, that is, what type of a physical quantity each of the above-described sensors 1 to 4 detects is not particularly related to an operation of a secondary failure preventing circuit (described as "SWC" in Fig. 1) 102 in the embodiment of the invention except for the power supply voltage that is required for an operation as will be described below; therefore, there is no need to limit the above-described sensors 1 to 4 to particular sensors.

In this configuration example, the second to fourth sensors (single power-supply type electronic components) 2 to 4 are operated by the 5-V power supply voltage while the first sensor (a dual power-supply type electronic component) 1 requires two power supply voltage systems. That is, more specifically, the first sensor 1 requires the two power supply voltages of 12 V and 5 V. Note that an example of such a sensor that requires the two power supply voltage systems is an oxygen sensor in the motor vehicle; however, it is needless to say that the first sensor 1 is not limited thereto.

In the embodiment of the invention, as will be described below, differing from the above-described first and second sensors 1, 2, the third and fourth sensors 3, 4 as wire-unshared single power-supply type electronic components are provided to be applied with the power supply voltage and connected to the ground without intervening a common wire for the application of the power supply voltage and the connection to the ground.

In the vehicle electronic control unit 101, the terminals that can be used for the power supply to and the ground connection of the above-described four sensors 1 to 4 are the three unit voltage supply terminals 21 to 23 and the three first to third ground connection terminals 25 to 27, and the number of each type of the terminals is smaller than the number of the sensors by one. For this reason, wiring therebetween is as will be described below.

First, a 12-V voltage application side of the first sensor 1 is connected to a positive electrode terminal of the vehicle battery 51 and the battery connection terminal 20 of the vehicle electronic control unit 101.

Both of a 5-V voltage application side of the first sensor 1 and a 5-V voltage application side of the second sensor (a first single power-supply type electronic component) 2 are connected to the first unit voltage supply terminal 21 of the vehicle electronic control unit 101.

A 5-V voltage application side of the third sensor 3 and a 5-V voltage application side of the fourth sensor 4 are respectively connected to the second unit voltage supply terminal 22 and the third unit voltage supply terminal 23 of the vehicle electronic control unit 101.

Meanwhile, both of a ground side of the first sensor 1 and a ground side of the second sensor 2 are connected to the third ground connection terminal 27 of the vehicle electronic control unit 101. In this connection, the ground side of the first sensor 1 and the ground side of the second sensor 2 are mutually connected (hereinafter referred to as a "shared ground connection point" for convenience of the description), and a shared ground connection point 31 and the third ground connection terminal 27 are connected by a shared ground wire 32.

A ground side of the third sensor 3 and a ground side of the fourth sensor 4 are respectively connected to the second ground connection terminal 25 and the first ground connection terminal 26 of the vehicle electronic control unit 101.

In the vehicle electronic control unit 101, first, the first unit voltage supply terminal 21 is connected to a first connection terminal 102a of the secondary failure preventing circuit 102.

In addition, the second and third unit voltage supply terminals 22, 23 and a second connection terminal 102b of the secondary failure preventing circuit 102 are mutually connected, and a connection point thereof (hereinafter referred to as a "unit voltage connection point" for convenience of the description) 33 is connected to a voltage output terminal 11a of the power supply IC 11.

That is, the secondary failure preventing circuit 102 is provided in a manner to be connected in series to a 5-V voltage (second power supply voltage) supply path to the first and second sensors 1, 2.

Meanwhile, each of the first to third ground connection terminals 25 to 27 is connected to a ground connection plate material 35 that is provided in the vehicle electronic control unit 101. Note that the ground connection plate material 35 is connected to a specified vehicle earth connection section.

The secondary failure preventing circuit 102 is a circuit that has a so-called switching function, and is configured to achieve a conductive state between the one connection terminal 102a and the other connection terminal 102b normally, that is, in the case where the shared ground wire 32 is in a state of not being broken but being connected normally and to achieve a non-conductive state between the one connection terminal 102a and the other connection terminal 102b in the case where it is determined that the shared ground wire 32 is broken.

Such a secondary failure preventing circuit 102 is configured to monitor an electric potential on the ground sides of the first and second sensors 2 in order to determine presence or absence of breakage of the shared ground wire 32, and to achieve the non-conductive state between the one connection terminal 102a and the other connection terminal 102b as described above in the case where the potential exceeds a specified threshold (reference voltage). Thus, the secondary failure preventing circuit 102 is configured to be able to receive the electric potential on the ground sides of the first and second sensors 1, 2 via the monitor terminal 28.

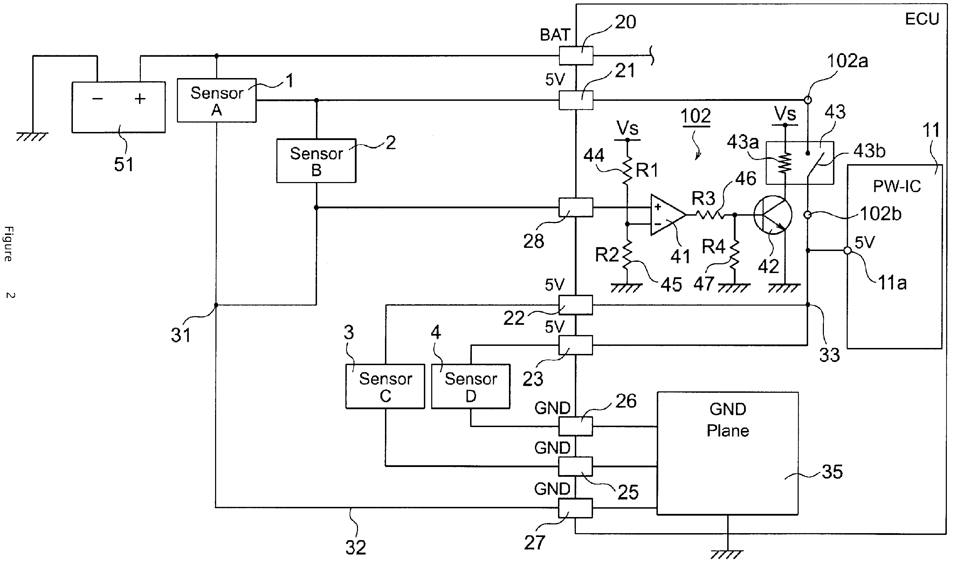

Next, a specific circuit configuration of the secondary failure preventing circuit 102 will be described with reference to Fig. 2.

Note that the same components as those in the circuit configuration depicted in Fig. 1 will not be described in detail, and the description will be centered on different points from the circuit configuration depicted in Fig. 1.

The secondary failure preventing circuit 102 in this circuit configuration example is constructed of a comparator 41, a transistor 42, and a relay 43 as primary components.

Hereinafter, a specific description will be made. First, an inverting input terminal of the comparator 41 is connected to the monitor terminal 28 and receives the electric potential on the ground sides of the first and second sensors 1, 2.

Meanwhile, a non-inverting input terminal of the comparator 41 receives a divided voltage at a mutual connection point between first and second resistors (respectively described as "R1", "R2" in Fig. 2) 44, 45 as the reference voltage for a comparison operation. The first and second resistors 44, 45 are connected in series between a supply line of a secondary circuit power supply voltage Vs and the ground.

An output terminal of the comparator 41 is connected to a base of the transistor 42 via a third resistor (described as "R3" in Fig. 1) 46, and the base of the transistor 42 is further connected to the ground via a fourth resistor (described as "R4" in Fig. 2) 47. Here, in the embodiment of the invention, an NPN bipolar transistor is used as the transistor 42.

Note that the secondary circuit power supply voltage Vs does not have to be limited to a particular voltage value, and any voltage value can be set therefor. For example, the secondary circuit power supply voltage Vs may be the battery voltage or 5 V output by the power supply IC 11.

A collector of the transistor 42 is connected to an end of an electromagnetic coil 43a of the relay 43 as a switching element, and the secondary circuit power supply voltage Vs is applied to the other end of this electromagnetic coil 43a. Meanwhile, an emitter of the transistor 42 is connected to the ground.

The relay 43 has a normally-closed connection point 43b that is brought into a closed state in a non-excited state where the electromagnetic coil 43a is not excited. One end of the normally-closed connection point 43b and the other end of the normally-closed connection point 43b are respectively connected to the first connection terminal 102a and the second connection terminal 102b.

Next, an operation in the above circuit configuration will be described.

First, in a state where the power supply voltage and the ground are normal, in other words, in a state where the shared ground wire 32 is normally connected between the shared ground connection point 31 and the third ground connection terminal 27, the voltage that is applied to the non-inverting input terminal via the monitor terminal 28 is almost equal to a ground potential.

Meanwhile, because the reference voltage that is set for the inverting input terminal of the comparator 41 is set to be higher than the ground potential, the comparator 41 outputs a low voltage that corresponds to a logical value Low. Accordingly, the transistor 42 is brought into the non-conductive state, and the electromagnetic coil 43a of the relay 43 is brought into the non-excited state. Thus, the normally-closed connection point 43b is maintained in the closed state. As a result, each of the first unit voltage supply terminal 21 and the second and third unit voltage supply terminals 22, 23 is brought into the conductive state with the voltage output terminal 11a of the power supply IC 11 via the normally-closed connection point 43b, and the voltage is normally supplied thereto by the power supply IC 11.

Next, in the case where the shared ground wire 32 is broken at any point for some reason, the ground sides of the first and second sensors 1, 2 are disconnected from the ground, which brings a state where the battery voltage is applied to the first unit voltage supply terminal 21 via the first and second sensors 1, 2. Thus, the electric potential on the ground sides of the first and second sensors 1, 2 is increased to be almost equal to the battery voltage.

Accordingly, the voltage of the non-inverting input terminal of the comparator 41, that is, the electric potential on the ground sides of the first and second sensors 1, 2 that is applied to the non-inverting input terminal via the monitor terminal 28 significantly exceeds the reference voltage of the inverting input terminal, the comparator 41 outputs a voltage that corresponds to a logical value High, and the transistor 42 is brought into the conductive state.

Thus, the electromagnetic coil 43a is excited, the normally-closed connection point 43b is brought into an opened state, and the conductive state of each of the first unit voltage supply terminal 21 and the second and third unit voltage supply terminals 22, 23 with the voltage output terminal 11a of the power supply IC 11 is canceled. As a result, differing from the conventional electronic device, flow of a reverse current (see Fig. 4) from the vehicle battery 51 via the power supply IC 11 and the third and fourth sensors 3, 4 is reliably avoided, and damage or failure spread to the power supply IC 11 and the third and fourth sensors 3, 4 arising from the breakage of the shared ground wire 32, that is, so-called secondary failure is reliably prevented.

In the above-described example, the NPN bipolar transistor is used as the transistor 42 in the specific circuit example of the secondary failure preventing circuit 102. However, the transistor 42 is not limited thereto, and it is needless to say that a transistor with another structure, such as a MOSFET, can also be used therefor.

In addition, it is configured to use the relay 43 to open/close the first and second connection terminals 102a, 102b. However, it is needless to say that a configuration of using a so-called semiconductor switch, such as the MOSFET, can also be adopted.

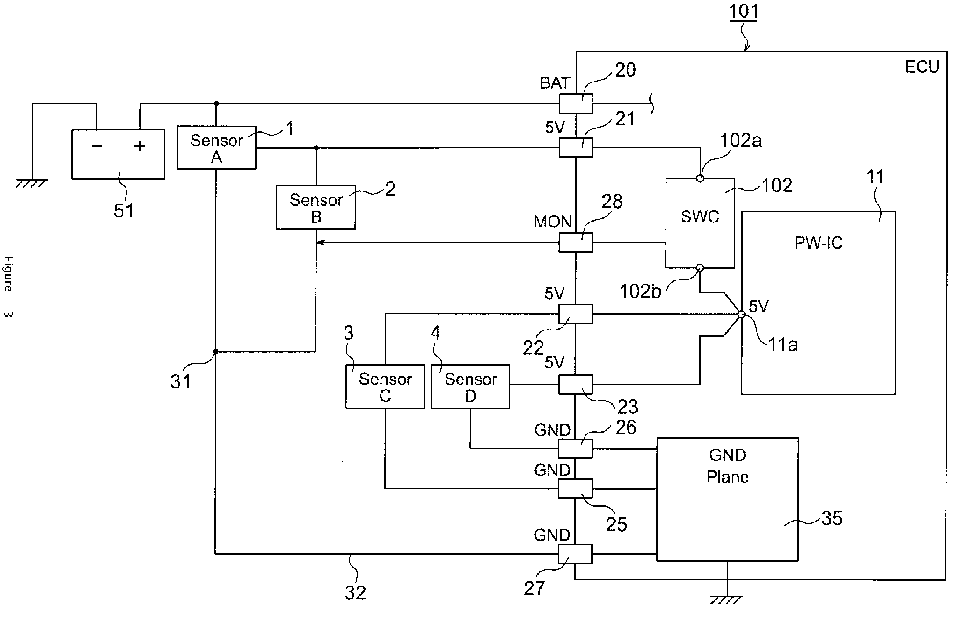

Furthermore, in the above-described example, it is configured that the second connection terminal 102b of the secondary failure preventing circuit 102 and the second and third unit voltage supply terminals 22, 23 are mutually connected and that the connection point 33 therebetween is connected to the voltage output terminal 11a of the voltage supply IC 11 (see Fig. 1 and Fig. 2). However, the invention is not limited to such a configuration. For example, as depicted in Fig. 3, it may be configured that the second connection terminal 102b and the second and third unit voltage supply terminals 22, 23 are separately connected to the voltage output terminal 11a.

### Industrial Applicability

The invention can be applied to an electronic device for which it is desired to reliably prevent or suppress secondary damage, failure, or the like of an electronic component having a certain power supply voltage, arising from breakage of a common ground wire to electronic components having different power supply voltages.

## Claims

1. An electronic device **characterized by** comprising:
a dual power-supply type electronic component (1) that requires a first power supply voltage and a second power supply voltage that is lower than the first power supply voltage;
a first single power-supply type electronic component (2) that requires the second power supply voltage;
at least one wire-unshared single power-supply type electronic component (3) that requires the second power supply voltage;
a unit power supply circuit (11) that generates and outputs the second power supply voltage on the basis of the first power supply voltage; and
a secondary failure preventing circuit (102) that prevents generation of a reverse current to the wire-unshared single power-supply type electronic component (3), arising from breakage of a common ground wire (32) to the dual power-supply type electronic component (1) and the first single power-supply type electronic component (2).

2. The electronic device according to claim 1 **characterized in that**
the secondary failure preventing circuit (102) is configured to be able to block application of the second power supply voltage to the dual power-supply type electronic component (1) and the first single power-supply type electronic component (2) in the case where a voltage on a ground side of each of the dual power-supply type electronic component (1) and the first single power-supply type electronic component (2) exceeds a specified reference voltage.

3. The electronic device according to claim 1 **characterized in that**
the secondary failure preventing circuit (102) is provided in a manner to be connected in series to a supply path of the second power supply voltage to the dual power-supply type electronic component (1) and the first single power-supply type electronic component (2), and uses a switching element (43) that is brought into an opened state only in the case where a voltage on a ground side of each of the dual power-supply type electronic component (1) and the first single power-supply type electronic component (2) exceeds a specified reference voltage.

4. The electronic device according to claim 1 or claim 2 **characterized in that**
the dual power-supply type electronic component (1) and the first single power-supply type electronic component (2) are provided such that the ground sides thereof are mutually connected and are also connected to the ground via the common ground wire (32) while application sides of the second power supply voltage thereof are mutually connected and are applied with the second power supply voltage.

5. The electronic device according to claim 1 or claim 2 **characterized in that**
the wire-unshared single power-supply type electronic component (3) is provided such that a ground side thereof is connected to the ground separately from the dual power-supply type electronic component (1) and the first single power-supply type electronic component (2) while an application side of the second power supply voltage thereof is applied with the second power supply voltage.
